(19) Europäisches Patentamt
European Patent Office
Office européen des brevets

(11) Veröffentlichungsnummer: **0 307 356**
**A2**

(12) # EUROPÄISCHE PATENTANMELDUNG

(21) Anmeldenummer: **88810597.0**

(22) Anmeldetag: **30.08.88**

(51) Int. Cl.4: **C 07 F 7/08**
C 07 F 7/22, C 07 F 7/30

(30) Priorität: **07.09.87 CH 3425/87**

(43) Veröffentlichungstag der Anmeldung:
**15.03.89 Patentblatt 89/11**

(84) Benannte Vertragsstaaten:
**AT CH DE FR GB IT LI NL SE**

(71) Anmelder: **CIBA-GEIGY AG**
**Klybeckstrasse 141**
**CH-4002 Basel (CH)**

(72) Erfinder: **Steinmann, Alfred, Dr.**
**Les Russilles**
**CH-1724 Praroman (CH)**

(54) **Organometallhaltige Verbindungen.**

(57) Organometallhaltige Styrolderivate der Formel I

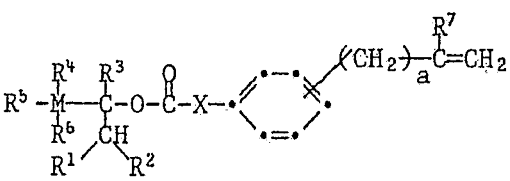

(I) ,

worin zum Beispiel M Si, X, O, $R^1$ und $R^2$ Wasserstoff, $R^4$ bis $R^6$ je Methyl, a Null und $R^7$ Wasserstoff oder Methyl bedeuten, und organometallhaltige Verbindungen der Formel VII

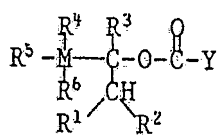

(VII) ,

worin M und $R^1$ bis $R^6$ z.B. die oben angegebene Bedeutung haben und Y beispielsweise 4-Nitrophenoxy ist, sind wertvolle Ausgangsstoffe für die Herstellung von organometallhaltigen Polymeren. Die Polymeren eignen sich zur Herstellung von trockenentwickelbaren Photoresists, wie sie bei der Erzeugung von strukturierten Bildern, insbesondere in der Mikroelektronik, benötigt werden.

EP 0 307 356 A2

**Beschreibung**

## Organometallhaltige Verbindungen

Die Erfindung betrifft organometallhaltige Styrolderivate, Verfahren zu deren Herstellung und die zur Herstellung der Styrolderivate verwendeten neuen Carbonylverbindungen sowie organometallhaltige Reagenzien, die mit Polymeren umgesetzt werden können, welche bestimmte funktionelle Gruppen enthalten.

Styrolderivate können bekannterweise radikalisch, anionisch oder kationisch zu Polystyrolen polymerisiert werden. Wenn solche Polymere funktionelle Gruppen enthalten, die durch Bestrahlung verändert, z.B. abgespalten werden, können sie als Resistmaterialien eingesetzt werden. So beschreibt die US 4,491,628 Resist-Stoffgemische, enthaltend ein Polymer mit säureunbeständigen Seitengruppen, wie z.B. tert.-Butylester-oder tert.-Butylcarbonatgruppen, und einen Photoinitiator, der bei Bestrahlung Säure generiert. Als Polymere werden vorzugsweise Vinylpolymere, wie Polystyrol oder Polyacrylat eingesetzt, während als Photoinitiatoren vor allem Oniumsalze, z.B. Diaryliodonium- oder Triarylsulfoniumsalze, verwendet werden. In den belichteten Stellen wird Säure generiert, die säureunbeständigen Gruppen werden abgespalten und dadurch die Polarität des Polymeren verändert. Durch die Wahl eines geeigneten polaren oder unpolaren Lösungsmittels für die Bildentwicklung können mit diesem Photoresist sowohl Positiv- als auch Negativbilder erzeugt werden.

Für viele Anwendungen, insbesondere in der Mikroelektronik, genügen lösungsmittelentwickelbare Resists den hohen Anforderungen nicht. Bevorzugt werden trockenentwickelbare Zusammensetzungen, d.h. Resists enthaltend Verbindungen, welche nach Bestrahlung in flüchtige Teilchen zerfallen, oder welche nach der Bestrahlung mit einem Plasma strukturiert werden können, ohne dass eine Nassentwicklung zur Bilderzeugung notwendig ist. Verschiedene Materialien wurden für diesen Zweck vorgeschlagen, so z.B. Polymethylmethacrylat, Polyethylenterephthalat, Nitrocellulose oder Polyisopren [s. beispielsweise H. Franke, Appl. Phys. Lett. 45(1), 110 ff (1984)]. Bei der Verwendung solcher Materialien treten häufig verschiedene Nachteile auf, wie niedrige Empfindlichkeit, mangelhafte Stabilität, Bildung von nichtflüchtigen Rückständen, mangelnde Resistenz gegen Sauerstoffplasma, oder mangelnde Auflösung.

In der EP-A 178 208 und in Microcircuit Engineering, 471-481 (1985) werden Polystyrole mit siliciumhaltigen Seitengruppen beschrieben, die sich zusammen mit bestimmten Photoinitiatoren als trockenentwickelbare positive Resists eignen. Dabei werden in den bestrahlten Stellen des Resistfilms Trialkylsilylgruppen, welche über Ethersauerstoffatome oder Aminstickstoffatome an die Polystyrolkette gebunden sind, abgespalten. Somit können mittels Plasmaentwicklung die bestrahlten Stellen des Films entfernt werden, während die nicht bestrahlten, siliciumhaltigen Bereiche des Films plasmaresistent sind. Der Nachteil dieses Systems liegt in der relativ hohen Lichtdosis von 80-120 mJ/cm$^2$, die für Bilderzeugung benötigt wird, wie auch in der ungenügenden Löslichkeit des Polymers in geeigneten Lösungsmitteln. Auch die Flüchtigkeit der bei der Bestrahlung abgespaltenen siliciumhaltigen Verbindungen ist nicht immer zufriedenstellend.

Die US 4,443,044 beschreibt siliciumhaltige Oximester der Methacrylsäure, deren Polymere ebenfalls als trockenentwickelbare, im kurzwelligen UV-Bereich empfindliche Positivresists eingesetzt werden können. Dabei sind Trimethylsilylgruppen über Methylenbrücken direkt an den Benzolring des Acetophenonoximrests der Polymer-seitenketten gebunden. Dieses System bedarf aber einer sehr hohen Lichtdosis von 1000 - 4500 mJ/cm$^2$, um eine genügende Abspaltung des siliciumhaltigen Rests zu erreichen. Zudem muss das System vor dem Plasmaätzvorgang bei erhöhter Temperatur im Hochvakuum erhitzt werden, um eine gute Bildstruktur zu erhalten.

Es wurde nun gefunden, dass Styrolderivate, die mindestens einen Substituenten auf Basis von bestimmten Silyl-, Stannyl- oder Germanylgruppen enthalten, polymerisiert werden können, wobei Polymere erhalten werden, welche im Gemisch mit katalytischen Mengen bestimmter Photoinitiatoren eine sehr hohe Strahlungsempfindlichkeit aufweisen. Zudem zeichnen sich diese Polymere durch eine hohe Sauerstoffplasmaresistenz aus. Falls zweckmässig, können die bestrahlten Polymere auch nass entwickelt werden, wobei je nach Polarität des verwendeten Entwicklers sowohl Positiv- als auch Negativbilder erzeugt werden können. Die bei der Bestrahlung freigesetzten, von den Polymerseitenketten abgespaltenen Verbindungen sind zudem leicht flüchtig, so dass für die Trockenentwicklung keine sehr hohen Temperaturen oder gar Hochvakuum nötig sind.

Gegenstand vorliegender Erfindung sind organometallhaltige Styrolderivate der Formel I

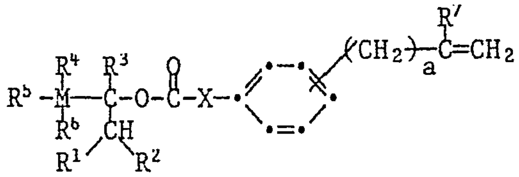

(I) ,

worin $R^1$ bis $R^6$ unabhängig voneinander $C_1$-$C_4$-Alkyl, $C_1$-$C_4$-Alkoxy, Phenyl, Benzyl, Phenoxy, eine Gruppe $-M(R^8)_3$ oder

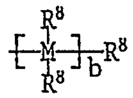 bedeuten oder

$R^3$ und $R^4$ zusammen für 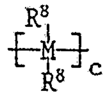

stehen und $R^1$ bis $R^3$ zusätzlich auch Wasserstoffatome sein können, $R^7$ Wasserstoff oder $C_1$-$C_4$-Alkyl und $R^8$ $C_1$-$C_4$-Alkyl, $C_1$-$C_4$-Alkoxy, Phenyl, Benzyl oder Phenoxy sind, M für Si, Ge, Sn, $CH_2Si$ oder OSi und X für O, S oder NH stehen und a Null oder 1, b eine ganze Zahl von 1 bis 6 und c eine ganze Zahl von 3 bis 6 bedeuten.

Die $C_1$-$C_4$-Alkylgruppen, bzw. die Alkylreste der $C_1$-$C_4$-Alkoxygruppen der Reste $R^1$ bis $R^8$ der erfindungsgemässen Styrolderivate können verzweigt oder vorzugsweise geradkettig sein und sind z.B. n-, iso-, sec.- oder tert-Butyl, n- oder iso-Propyl, Ethyl und insbesondere Methyl.

Besonders bevorzugte organometallhaltige Verbindungen der Formel I sind Siliciumverbindungen, wobei M $CH_2Si$, OSi oder insbesondere Si bedeutet. Ebenso bevorzugt sind erfindungsgemässe Styrolderivate, worin X S oder insbesondere O bedeutet.

Die vorliegenden Styrolderivate enthalten definitionsgemäss mindestens ein Silicium-, Germanium- oder Zinnatom M, können aber auch zwei oder mehrere dieser Atome aufweisen. Wenn die Substituenten $R^3$ und $R^4$ zusammen einen zweiwertigen Rest

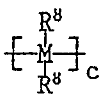

bedeuten, weisen die erfindungsgemässen Verbindungen z.B. einen ein Kohlenstoffatom und mehrere Metallatome enthaltenden Ring auf. Dabei sind Verbindungen mit fünf- und sechsgliedrigen Ringen bevorzugt. Bevorzugt sind auch erfindungsgemässe Verbindungen, worin die Reste $R^4$, $R^5$ und $R^6$ gleich sind.

Im allgemeinen werden diejenigen erfindungsgemässen Styrolderivate bevorzugt, welche bei Bestrahlung in Anwesenheit eines säurefreisetzenden Photoinitiators neben $CO_2$ eine möglichst leichtflüchtige Verbindung I* abspalten

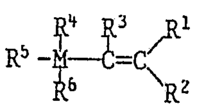 (I*).

Es versteht sich von selbst, dass dieses Ziel durch geeignete Kombinationen der Substituenten $R^1$ bis $R^6$ und des Metallatoms M erreicht wird.

Wenn einer der Reste $R^1$ bis $R^6$ der erfindungsgemässen Verbindungen für

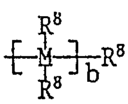

steht, bedeutet b vorzugsweise eine ganze Zahl von 1 bis 3, insbesondere 1.

Bevorzugt werden auch Styrolderivate der Formel I, worin $R^1$ und $R^2$ je Wasserstoff, $R^3$ Methyl oder $Si(CH_3)_3$ und $R^4$ bis $R^6$ je Methyl bedeuten oder worin $R^3$ und $R^4$ zusammen für

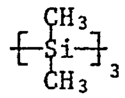 oder 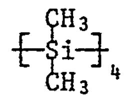

stehen und insbesondere Styrolderivate der Formel I, worin $R^1$ und $R^2$ je Wasserstoff, $R^3$ Methyl oder $Si(CH_3)_3$ und $R^4$ bis $R^6$ je Methyl bedeuten. Bevorzugt werden zudem Verbindungen der Formel I, worin a Null und $R^7$ Wasserstoff oder Methyl bedeuten.

Besonders bevorzugt sind Verbindungen der Formel I, worin $R^1$ und $R^2$ je Wasserstoff bedeuten und $R^3$ bis $R^6$ jeweils für eine Methylgruppe stehen. Ganz besonders bevorzugte erfindungsgemässe Styrolderivate sind 4-(2′-Trimethylsilyl-2′-propoxycarbonyloxy)styrol, 4-(2′-Trimethylsilyl-2′-propoxycarbonyloxy)-α-methylstyrol und 4-(1′,1′-Bistrimethylsilylethoxycarbonyloxy)-α-methylstyrol.

Die erfindungsgemässen Styrolderivate der Formel I können hergestellt werden entweder

a) direkt durch Umsetzung eines organometallhaltigen Alkohols der Formel II

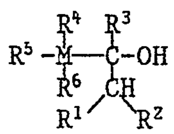 (II)

mit einem Chlorameisensäurederivat der Formel IIIa

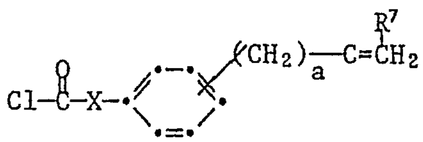 (IIIa)

oder durch Umsetzung eines organometallhaltigen Chlorformiats der Formel V

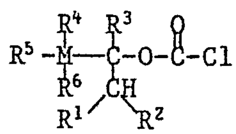 (V)

mit einer Verbindung der Formel VIa

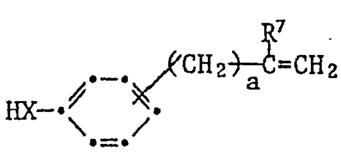 (VIa)

oder

b) über die entsprechenden Carbonylverbindungen durch Umsetzung des organometallhaltigen Alkohols der Formel II mit einem Chlorameisensäurederivat der Formel IIIb

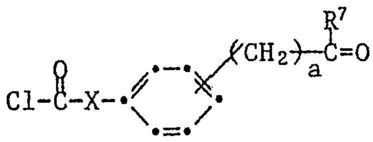

(IIIb)

zur Carbonylverbindung der Formel IV

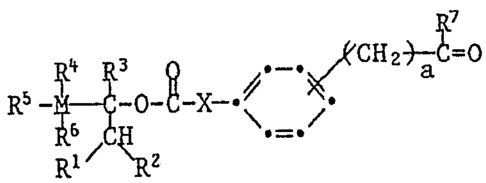

(IV) oder

durch Umsetzung des organometallhaltigen Chlorformiats der Formel V mit einer Verbindung der Formel VIb

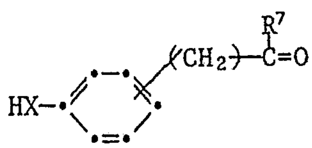

(VIb)

zur Verbindung der Formel IV und anschliessende Wittig-Reaktion der Carbonylverbindung der Formel IV mit einem Phosphorylid, wobei die Symbole $R^1$ bis $R^7$, M, X und a in den Formeln II bis VI die im Anspruch 1 angegebene Bedeutung haben.

Organometallhaltige Alkohole der Formel II sind bekannt oder können auf bekannte Weise hergestellt werden. So wird in J. Organomet. Chem. 49 (1973) C9-C12 die Herstellung eines siliciumhaltigen Alkohols durch Umsetzung von Trimethylchlorsilan mit Aceton beschrieben. Organometallhaltige Alkohole der Formel II können auch, wie in J.Org.Chem. 45 (1980) 3571-3578, in Zh. Obshch. Khim. 36 (1966) 1709 in Tetrahedron Lett. 1976, 1591-1594 oder in J. Organomet. Chem. 1981 33-47, beschrieben, oder auf analoge Weise hergestellt werden.

Chlorameisensäurederivate der Formel III sind ebenfalls bekannt und können z.B. durch Umsetzung von Phosgen mit einem substituierten Phenol, Thiophenol oder Anilin der Formel VI, vorzugsweise in Anwesenheit einer Base, z.B. eines tertiären Amins, wie Pyridin oder Dimethylanilin, hergestellt werden. Auf anologe Art können auch organometallhaltige Chlorformiate der Formel V synthetisiert werden, indem ein Alkohol der Formel II mit Phosgen umgesetzt wird. Eine Herstellungsmethode von Chlorameisensäurederivaten der Formel IIIa ist z.B. in Angew. Makromol. Chem. 60/61 (1977) 125-137 oder in der DE-OS 25 08 512 beschrieben. Chlorameisensäurederivate der Formel IIIa können auch durch Umsetzung der entsprechenden Verbindungen der Formel VIa mit Phosgen, wie z.B. in der DE-PS 1 193 031 beschrieben, hergestellt werden. Eine Vielzahl geeigneter Synthesen von Chlorameisensäurederivaten, wie z.B. Chlorformiaten, sowie deren Reaktionsprodukte mit Alkoholen, Thiolen und Aminen ist z.B. in Chem. Rev. 64 (1964) 645-687 beschrieben.

Die Verbindungen der Formel VI sind bekannt und sind im allgemeinen auch im Handel erhältlich.

Die organometallhaltigen Carbonylverbindungen der Formel IV wurden für die Herstellung der erfindungsgemässen Verbindungen der Formel I entwickelt und stellen somit ebenfalls einen Gegenstand der Erfindung dar. Sie können z.B. mittels einer Wittig-Reaktion in bekannter Weise durch Umsetzung mit einem Phosphorylid in die Styrolderivate der Formel I übergeführt werden. Geeignete Phosphorylide können z.B. durch Umsetzung eines Methyltriarylphosphoniumsalzes, wie Methyltriphenylphosphoniumbromid, mit starker Base, wie Natriumhydrid oder Kalium-tert.-butylat hergestellt werden. Wittig-Reaktionen sind in vielen Uebersichten beschrieben, wie z.B. in House "Modern Synthetic Reactions", 2. Aufl. Seiten 682-709, W.A. Benjamin Inc., Menlo Park CA, U.S.A., 1972.

Ein weiterer Gegenstand der Erfindung sind auch organometallhaltige Verbindungen der Formel VII

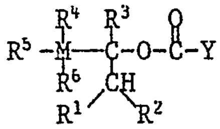 (VII) ,

worin $R^1$ bis $R^6$ und M die oben bei Formel I angegebene Bedeutung haben und Y eine für eine nukleophile Substitution geeignete Abgangsgruppe ist.

Die bevorzugte Bedeutung der Symbole $R^1$ bis $R^7$, M, X und a in den erfindungsgemässen Verbindungen der Formeln IV und VII stimmt mit der bevorzugten Bedeutung dieser Symbole bei den Verbindungen der Formel I überein.

Die Verbindungen der Formel VII sind ebenfalls wertvolle Ausgangsstoffe für die Herstellung von organometallhaltigen Polymeren, indem sie z.B. mit bestimmten nukleophilen funktikonellen Gruppen, wie Hydroxyl-, Mercapto-, Amino- oder Iminogruppen, der Polymere umgesetzt werden und dadurch der Rest der Formel VII*

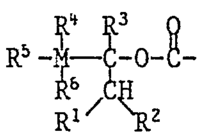 (VII*)

als organometallhaltige Gruppierung an das Polymer gebunden sind. Für diese Umsetzung geeignete Polymere sind z.B. Polyalkohole und Polyphenole, wie Polyvinylalkohol, Novolake oder Poly-4-hydroxystyrol, Polythiole oder Polyimine.

Für eine nukleophile Substitution geeignete Abgangsgruppen Y sind bekannt. Die wichtigste Voraussetzung bei der Wahl der Abgangsgruppe ist, dass diese weniger nukleophil ist als die funktionellen Gruppen des Polymers, mit denen sie umgesetzt werden soll.

Besonders geeignete Abgangsgruppen Y der Verbindungen der Formel VII sind mit Elektronakzeptorgruppen substituierte Phenoxy-Reste oder fünf- oder sechsgliedrige Heterocyclen mit mindestens einem, vorzugsweise zwei Heteroatomen, wie z.B. O-, S- und insbesondere N-Atomen im Ring, welche über einen dieser Heteroatome an die Carbonylgruppe im Molekül gebunden sind. Beispiele geeigneter Reste Y sind z.B. 1-Imidazolyl oder eine Gruppe der Formel VIII

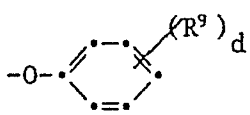 (VIII),

worin $R^9$ Halogen, insbesondere Fluor, Chlor oder Brom, $NO_2$, CN oder $CF_3$ und d eine ganze Zahl von 1 bis 5, vorzugsweise von 1 bis 3, bedeuten. Ein besonders geeigneter Rest der Formel VIII ist 4-Nitrophenoxy.

Die Verbindungen der Formel VII können in an sich bekannter Weise, z.B. durch Umsetzung der organometallhaligen Chlorformiate der Formel V mit einer Verbindung der Formel IX

YH (IX)

hergestellt werden.

Ein anderer geeigneter Syntheseweg ist die Umsetzung der organometallhaltigen Alkohole der Formel II mit einem Chlorameisensäurederivat der Formel X

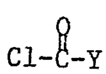 (X),

oder mit einer Carbonylverbindung der Formel XI

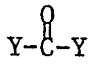 (XI),

wobei die Verbindungen der Formeln II und V sowie Y in den Formeln IX, X und XI die oben angegebene Bedeutung haben.

Die Verbindungen der Formeln X oder XI können z.B. durch Umsetzung von Phosgen mit einer Verbindung der Formel IX hergestellt werden.

Die Verbindungen der Formel IX sind bekannt und im allgemeinen im Handel erhältlich.

Der Syntheseweg über Verbindungen der Formel XI bei der Herstellung von Verbindungen der Formel VII ist besonders geeignet, wenn Y einen der oben erwähnten heterocyclischen Reste bedeutet. Eine geeignete Verbindung der Formel XI ist z.B. 1,1′-Carbonyldiimidazol.

Wie eingangs erwähnt, stellen die erfindungsgemässen Verbindungen wertvolle Ausgangsstoffe für die Herstellung von organometallhaltigen Polymeren dar, welche im Gemisch mit geeigneten Photoinitiatoren als strahlungsempfindliches und plasmaresistentes, trockenentwickelbares Resistmaterial eingesetzt werden können.

Die nachfolgenden Beispiele erläutern die Erfindung näher.

Beispiel 1: 2-Trimethylsilyl-2-propanol

In einem 10 l Planschliffgefäss mit mechanischem Rührer werden unter Stickstoff 83 g (12 Mol) Lithiumpulver vorgelegt. Dazu gibt man 6 l trockenes THF und kühlt auf 0°C ab. 1500 g Trimethylchlorsilan (13,8 Mol) und 313 g Aceton (5,4 Mol) werden gemischt und via Tropftrichter zur Lithiumsuspension getropft. Dabei soll die Reaktionstemperatur 0°C betragen. Nach der Zugabe wird die Kühlung entfernt und 1 - 2 Stunden bei 50°C gerührt. Die Lösung wird vom Salz und vom überschüssigen Lithium abgetrennt. Der Rückstand wird mit n-Pentan gewaschen und das Filtrat eingeengt. Dabei wird bei Normaldruck zuerst das Lösungsmittel über eine verspiegelte Füllkörperkolonne abgetrennt. Danach wird bei 20 mbar der Trimethylsilylether von 2-Trimethylsilyl-2-propanol gewonnen. Man erhält 300 g (28 %) einer farblosen Flüssigkeit vom Siedepunkt 47-48°C.

$^1$H-NMR ($CCl_4$):
0 ppm (s, 9H) $(H_3C)_3Si$-C
0,1 ppm (s, 9H) $(H_3C)_3Si$-O
1,3 ppm (s, 6H) $(H_3C)_2C$

| Elementaranalyse: | berechnet | gefunden |
|---|---|---|
| % C | 52,8 | 51,6 |
| % H | 11,8 | 11,7 |

232 g des Trimethylsilylethers werden in 900 ml Diethylether gelöst und mit 700 ml 15 %iger HCl versetzt. Unter starkem Rühren wird das 2-Phasengemisch etwa eine Stunde lang unter Rückfluss erhitzt. Die organische Phase wird abgetrennt, einmal mit Wasser und dann gründlich mit Natriumbicarbonatlösung gewaschen, getrocknet und der Ether wird bei Normaldruck abgedampft. Der Rückstand wird bei 100 mbar über eine Füllkörperkolonne destilliert. Man erhält 63 g (65 %) einer klaren Flüssigkeit, die bei 65°C destilliert und gemäss GC eine Reinheit von mehr als 97 % aufweist.

$^1$H-NMR ($CCl_4$):
0 ppm (s, 9H) $(H_3C)_3Si$
1,1 ppm (s, 6H) $(H_3C)_2C$
1,7 ppm (s, 1H) HO-

| Elementaranalyse: | berechnet | gefunden |
|---|---|---|
| % C | 54,48 | 54,19 |
| % C | 12,19 | 11,98 |

Beispiel 2: 4-(2′-Trimethylsilyl-2′-propoxycarbonyloxy)styrol

Unter Stickstoff werden in einem 5 l Planschliffgefäss mit mechanischem Rührer und Thermometer 244 g (2 Mol) 4-Hydroxybenzaldehyd und 2 l 2M Phosgenlösung in Toluol (4 Mol Phosgen) vorgelegt. Bei -5°C tropft man 242 g (2 Mol) Dimethylanilin dazu. Nach dem Zutropfen wird noch 2 Stunden bei 0°C gerührt. Man lässt auf Raumtemperatur erwärmen, treibt mit Stickstoff das überschüssige Phosgen aus und giesst auf Eiswasser. Die organische Phase wird gründlich mit verdünnter Salzsäure gewaschen und mit Natriumsulfat getrocknet. Am Rotationsverdampfer wird das Lösungsmittel abdestilliert. Der Rückstand wird am Hochvakuum destilliert. Man erhält 250 g (68 %) 4-(Chlorcarbonyloxy)benzaldehyd, eine glasklare Flüssigkeit, die bei 84°C/0,2 mbar siedet. Beim Abkühlen wird die Flüssigkeit fest; der Schmelzpunkt liegt etwas oberhalb der Raumtemperatur.

| Elementaranalyse: | berechnet | gefunden |
|---|---|---|
| % C | 52,06 | 51,07 |
| % H | 2,73 | 2,74 |
| % Cl | 19,21 | 21,26 |

43 g (233 mmol) dieses Chlorformiates werden in 30 ml Methylenchlorid gelöst und unter Stickstoff zu einer Lösung von 30,8 g (233 mmol) 2-Trimethylsilyl-2-propanol und 18,4 g Pyridin (233 mmol) in 120 ml Methylenchlorid getropft. Dabei wird die Lösungstemperatur auf ≦ 5°C gehalten. Nach dem Zutropfen lässt man auf Raumtemperatur erwärmen. Nach 12 Stunden unter Stickstoff wird vom Salz abgetrennt und die organische Phase mit verdünnter Salzsäure, Wasser- und Natriumbicarbonatlösung gewaschen. Nach dem Trocknen wird vom Lösungsmittel befreit. Der Rückstand wird über Silicagel mit Chloroform als Laufmittel chromatographiert. Man erhält 30,6 g (46 %) 4-(2′-Trimethylsilyl-2′-propyloxycarbonyloxy)benzaldehyd als farblose Flüssigkeit.

$^1$H-NMR (Aceton-$d_6$):
0,1 ppm (s, 9H) $(H_3C)_3Si$
1,5 ppm (s, 6H) $(H_3C)_2C$
7,3-7,9 ppm (m, 4H) H-Ar.
10 ppm (s, 1H) CHO

| Elementaranalyse: | berechnet | gefunden |
|---|---|---|
| % C | 59,97 | 59,62 |
| % H | 7,19 | 7,18 |
| % Si | 10,01 | 9,95 |

Das Benzaldehyderivat wird mittels Wittigreaktion ins entsprechende Styrolderivat überführt: In einem 1 l 3-Hals-Rundkolben mit Tropftrichter und Thermometer werden 38,6 g (108 mmol) Methyltriphenylphosphoniumbromid in 400 ml trockenem THF vorgelegt. Dazu gibt man 12,2 g (108 mmol) Kalium-tert.-butylat und lässt unter Stickstoff 1 Stunde bei Raumtemperatur rühren. 20 g (72 mmol) Benzaldehydderivat, gelöst in 180 ml THF werden nun bei Raumtemperatur zugetropft. Nach 15 Stunden zeigt das DC (Toluol/Hexan = 1:1) nur das Produkt. Man giesst auf Eis und zieht zweimal mit n-Hexan aus. Die organische Phase wird zweimal mit Wasser gewaschen, getrocknet und eingedampft. Der Rückstand wird über eine Silicagelsäule mit Toluol/Hexan = 1:1 chromatographiert. Man erhält 13 g (65 %) einer farblosen Flüssigkeit, die sich am Hochvakuum destillieren lässt (Siedepunkt 110°C/0,05 mbar).

$^1$H-NMR (Aceton-$d_6$):
0,05 ppm (s, 9H) $(H_3C)_3Si$
1,45 ppm (s, 6H) $(H_3C)_2C$
5,1-5,8 ppm (m, 2H) $H_2C=$
6,5-6,8 ppm (m, 1H) $=CH-$
7,0-7,5 ppm (m, 4H) H-Ar.

| Elementaranalyse: | berechnet | gefunden |
|---|---|---|
| % C | 64,71 | 63,95 |
| % H | 7,97 | 7,91 |
| % Si | 10,09 | 10,24 |

Beispiel 3: 4-(2′-Trimethylsilyl-2′-propoxycarbonyloxy)-α-methylstyrol

Dieses Monomer wird ausgehend von 4-Hydroxyacetophenon genau wie das in Beispiel 2 beschriebene Styrolderivat hergestellt. Die Ausbeuten und die physikalischen Daten der hergestellten Verbindungen sind wie folgt:

4-(Chlorcarbonyloxy)acetophenon

Ausbeute 82 %, Schmelzpunkt 33°C.

$^1$H-NMR ($CDCl_3$):
2,6 ppm (s, 3H)

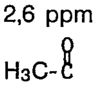

7,25-8,10 ppm (m, 4H) H-Ar.

| Elementaranalyse: | berechnet | gefunden |
|---|---|---|
| % C | 54,43 | 54,41 |
| % H | 3,55 | 3,59 |
| % Cl | 17,85 | 17,78 |

<u>4-(2′-Trimethylsilyl-2′-propoxycarbonyloxy)acetophenon</u>

Ausbeute 68 %, Schmelzpunkt 41°C.
$^1H$-NMR (Aceton-$d_6$):
0,1 ppm (s, 9H) $(H_3C)_3Si$
1,5 ppm (s, 6H) $(H_3C)_2C$
2,6 ppm (s, 3H) $H_3C-\overset{\overset{O}{\|}}{C}$
7,25-8,1 ppm (m, 4H) H-Ar.

| Elementaranalyse: | berechnet | gefunden |
|---|---|---|
| % C | 61,19 | 60,90 |
| % H | 7,53 | 7,48 |

<u>4-(2′-Trimethylsilyl-2′-propoxycarbonyloxy)-α-methylstyrol</u>

Ausbeute 53 %, Siedepunkt 118°C/0,04 mbar.
$^1H$-NMR (Aceton-$d_6$):
0,1 ppm (s, 9H) $(H_3C)_3Si$
1,5 ppm (s, 6H) $(H_3C)_2C$
2,1 ppm (m, 3H) $H_3C-C=C$
5,1-5,4 ppm (m, 2H) $H_2C=C$
7,1-7,6 ppm (m, 4H) H-Ar.

| Elementaranalyse: | berechnet | gefunden |
|---|---|---|
| % C | 65,71 | 65,77 |
| % H | 8,27 | 8,30 |

<u>Beispiel 4: Poly[4-(2′-Trimethylsilyl-2′-propoxycarbonyloxy)styrol]</u>

10 g (36 mmol) 4-(2′-Trimethylsilyl-2′-propoxycarbonyloxy)styrol (hergestellt gemäss Beispiel 2) werden in 20 ml Toluol gelöst und mit 1 Mol% 2,2′-Azobisisobutyronitril versetzt. Die Lösung wird vom Sauerstoff befreit und unter Stickstoff bei 70°C polymerisiert. Nach ein paar Stunden wird die viskose Lösung mit 50 ml Methylenchlorid verdünnt und auf 500 ml Methanol gegossen. Das ausgefallene Polymer wird nochmals in Methylenchlorid gelöst und erneut in Methanol ausgefällt. Das Polymer wird bei 50°C am Hochvakuum getrocknet. Ausbeute 6 g (60 %).
$^1H$-NMR ($CDCl_3$):
0,1 ppm (s, 9H) $(H_3C)_3Si$
0,75 - 2,25 (m/s, 9H) $-CH_2-\underset{|}{C}H-$ und $(H_3C)_2C$
6,2 - 7,1 ppm (m, 4H) H-Ar.

| Elementaranalyse: | berechnet | gefunden |
|---|---|---|
| % C | 64,71 | 64,75 |
| % H | 7,96 | 7,92 |

Mittels Gelpermeationschromatographie (GPC) in Tetrahydrofuran mit Polystyrol als Standard wird ein Molekulargewicht von $\overline{M}_n = 42000$ und $\overline{M}_w = 87000$ bestimmt.
Thermogravimetrische Analyse: Bei einer Aufheizgeschwindigkeit von 4°C/Min. in Luft hat man bei 160°C ca. 10 % Gewichtsverlust. Bei 175°C ist die Verbindung vollständig decarboxyliert. Der Gewichtsverlust beträgt 55 %, was genau der Abspaltung von $CO_2$ und von Isopropenyltrimethylsilan entspricht.

Beispiel 5: Poly[4-(2′-Trimethylsilyl-2′propoxycarbonyloxy)-α-methylstyrol]

In einem 100 ml Rundkolben mit Glasaufsatz werden 20 g (68 mmol) des Monomers in 60 ml Methylenchlorid gelöst. Man entfernt den Sauerstoff aus der Lösung und gibt unter Stickstoff bei -78° C 1,1 ml einer 1M Lösung von $BF_3 \bullet Et_2O$ in Methylenchlorid dazu. Nun lässt man bei -20 bis -40° C polymerisieren. Nach 18 Stunden wird die viskose Lösung in 1 Liter Methanol gegossen. Das ausgefallene Polymer wird abgetrennt, getrocknet und nochmals in Methylenchlorid/Methanol umgefällt. Danach wird bei 50° C am Hochvakuum getrocknet. Man erhält 13 g (65 %) des Polymers.

$^1$H-NMR ($CDCl_3$):
0,1 ppm (s, 9H) $(CH_3)_3Si$
1,0-2,1 ppm (m/s, 11H) $CH_3$-C, $-CH_2-$, $CH_3$-C-$CH_3$
6,4-7,2 ppm (m, 4H) H-Ar.

| Elementaranalyse: | berechnet | gefunden |
|---|---|---|
| % C | 65,71 | 65,73 |
| % H | 8,27 | 8,20 |
| % Si | 9,60 | 9,68 |

GPC-Messungen in THF zeigen ein $\overline{M}_n$ von 33000 und ein $\overline{M}_w$ von 84000.

TGA-Analyse: Bei einer Aufheizgeschwindigkeit von 4° C/Minute in Luft hat man bei ca. 155° C 10 % Gewichtsverlust und bei 171° C ca. 53 % Gewichtsverlust. Der Gewichtsverlust von 53 % entspricht der vollständigen Abspaltung von $CO_2$ und Isopropenyltrimethylsilan.

Beispiel 6: 4-(2′-Trimethylsilyl-2′-propoxycarbonyloxy)nitrobenzol

Unter Stickstoff werden in einem 100 ml Glaskolben, der mit Thermometer, Tropftrichter und Magnetrührer ausgerüstet ist, 10 g (76 mmol) 2-Trimethylsilyl-2-propanol, 6 g (76 mmol) Pyridin und 30 ml Methylenchlorid vorgelegt und die Lösung wird auf 0° C abgekühlt. 15,2 g (76 mmol) Chlorameisensäure-4-nitrophenylester werden in 20 ml Methylenchlorid gelöst und so zur vorgelegten Lösung getropft, dass die Temperatur zwischen 0° C und 5° C bleibt. Nach dem Zutropfen lässt man auf Raumtemperatur erwärmen und rührt noch etwa 1 Stunde nach. Man giesst auf Eiswasser, wäscht die organische Phase mit 1N HCl und anschliessend mit $NaHCO_3$. Die getrocknete organische Phase wird eingeengt und der Rückstand mit n-Hexan umkristallisiert. Man erhält 10 g (44 %) kristalline Substanz vom Schmelzpunkt 61° C.

$^1$H-NMR (Aceton-$d_6$):
0,1 ppm (s, 9H) $(H_3C)_3Si$
1,55 ppm (s, 6H) $(H_3C)_2C$
7,4-8,1 ppm (m, 4H) H-Ar.

| Elementaranalyse: | berechnet | gefunden |
|---|---|---|
| % C | 52,51 | 52,31 |
| % H | 6,44 | 6,41 |
| % N | 4,71 | 4,60 |

Beispiel 7: 1-(2′-Trimethylsilyl-2′-propoxycarbonyl)imidazol

Unter Stickstoff werden in einem Sulfierkolben, der mit Kühler, Thermometer und Magnetrührer versehen ist, 10 g (76 mmol) 2-Trimethylsilyl-2-propanol, 14,7 g (91 mmol) 1,1′-Carbonyldiimidazol und 50 ml Methylenchlorid vorgelegt. Dann wird die Mischung während 21 Stunden unter Rückfluss gerührt. Man giesst auf Eiswasser, trennt die Phasen und wäscht die organische Phase noch zweimal mit Wasser. Die organische Phase wird getrocknet, am Rotationsverdampfer eingeengt und der Rückstand im Hochvakuum destilliert. Man erhält 11,3 g (66 %) einer farblosen Flüssigkeit mit einem Siedepunkt von 90° C/0,1 mbar.

$^1$H-NMR (Aceton-$d_6$):
0,2 ppm (s, 9H) $(H_3C)_3Si$
1,6 ppm (s, 6H) $(H_3C)_2C$
7,74 und 8,1 ppm (s, 3H) H-Imidazol

| Elementaranalyse: | berechnet | gefunden |
|---|---|---|
| % C | 53,06 | 52,31 |
| % H | 8,02 | 8,02 |
| % N | 12,38 | 12,40 |

Beispiel 8: 4-(1',1'-Bistrimethylsilylethoxycarbonyloxy)-α-methylstyrol

Die Kondensationsreaktion zwischen 4-(Chlorcarbonyloxy)acetophenon und 1,1-Bistrimethylsilylethanol (hergestellt nach Tetrahedron Lett., 1976, 1591-1594) in Methylenchlorid verläuft analog zu der im Beispiel 2 beschriebenen Kondensation. Nach der säulenchromatographischen Reinigung erhält man einen Festkörper, der in Hexan umkristallisiert werden kann.

4-(1',1'-Bistrimethylsilylethoxycarbonyloxy)acetophenon

Ausbeute 60 %, Schmelzpunkt 79,5°C.
$^1$H-NMR ($CDCl_3$):
$(CH_3)_3Si$ (18H, s) : 0,12 ppm
$CH_3$-C (3H, s) : 1,6 ppm
$CH_3$-C=O (3H, s) : 2,6 ppm
Aromat (4H, m) : 7,2-8,05 ppm

| Elementaranalyse: | berechnet | gefunden |
|---|---|---|
| % C | 57,91 | 58,01 |
| % H | 8,01 | 8,13 |
| % Si | 15,93 | 15,92 |

4-(1',1'-Bistrimethylsilylethoxycarbonyloxy)-α-methylstyrol

Die Wittigreaktion wird analog dem Beispiel 2 durchgeführt. Nach der säulenchromatographischen Reinigung erhält man eine farblose Flüssigkeit in 41 % Ausbeute.
$^1$H-NMR ($CDCl_3$):
$(CH_3)_3Si$ (18H, s) : 0,15 ppm
$CH_3$-C (3H, s) : 1,6 ppm
$CH_3$-C= (3H, m) : 2,15 ppm
$CH_2$=C (2H, m) : 5,04-5,33 ppm
Aromat (4H, m) : 7,00-7,53 ppm

| Elementaranalyse: | berechnet | gefunden |
|---|---|---|
| % C | 61,66 | 61,57 |
| % H | 8,63 | 8,77 |
| % Si | 16,02 | 16,08 |

Beispiel 9: Poly[4-(1',1'-Bistrimethylsilylethoxycarbonyloxy)-α-methylstyrol]

In einem 250 ml Rundkolben mit Magnetrührer werden 20 g (57 mmol) 4-(1',1'-Bistrimethylsilylethoxycarbonyloxy-α-methylstyrol (hergestellt gemäss Beispiel 8) in 60 ml wasserfreiem Methylenchlorid gelöst und an einer Vakuum/Stickstofflinie mit Hilfe der Gefrier-/Tautechnik sauerstofffrei gemacht. Die Lösung wird auf minus 60°C gekühlt und mit 1,2 mmol frisch destilliertem $BF_3 \bullet Et_2O$ versetzt. Zwischen minus 60°C und minus 40°C lässt man 18 Stunden lang polymerisieren. Die viskose Lösung wird in 1 l Methanol ausgefällt. Das weisse Polymerpulver wird getrocknet und in 100 ml THF gelöst, filtriert und erneut in 1 l Methanol ausge fällt. Man trennt das Polymer ab, lässt an der Luft trockensaugen und trocknet am Hochvakuum bei 50°C. Ausbeute: 6,1 g weisses Polymerpulver (31 %).

| Elementaranalyse: | berechnet | gefunden |
|---|---|---|
| % C | 61,66 | 61,60 |
| % H | 8,63 | 8,62 |
| % Si | 16,02 | 16,03 |

GPC (THF):
$\overline{M}_n$ = 52 000
$\overline{M}_w$ = 102 000
Thermogravimetrische Analyse: Das Polymer zerfällt bei 170°C in $CO_2$ und 1,1-Bistrimethylsilylethen.

Beispiel 10: Herstellung von 4-(2'-Trimethylsilyl-2'propoxycarbonyloxy)-α-methylstyrol durch Umsetzung von 2-Trimethylsilyl-2-propanol mit 4-Chlorformyloxy-α-methylstyrol

In einem 250 ml Dreihalskolben mit Tropftrichter und Thermometer werden 10 g (75,6 mmol) 2-Trimethylsilyl-2-propanol und 7,2 g (91 mmol) Pyridin in 100 ml wasserfreiem Methylenchlorid gelöst.

Nachdem man die Lösung auf 0° C abgekühlt hat, tropft man 17,8 g (90,5 mmol) 4-Chlorformyloxy-α-methylstyrol (hergestellt gemäss Beispiel 6.2 der DE-OS 25 08 512) dazu. Nach dem Zutropfen lässt man auf Raumtemperatur erwärmen und rührt die Suspension noch eine Stunde lang nach. Das entstandene Pyridinhydrochlorid wird abgetrennt und die organische Phase je zweimal mit 1N HCl, Wasser und gesättigter Natriumbicarbonatlösung gründlich gewaschen. Dann wird mit Natriumsulfat getrocknet und am Rotationsverdampfer eingeengt. Das flüssige Produkt wird über eine Kieselgelsäule mit Toluol als Laufmittel gereinigt. Man erhält 14 g (40 mmol, 63 % Ausbeute) 4-(2'-Trimethylsilyl-2'-propoxycarbonyloxy)-α-methylstyrol, dessen Eigenschaften identisch mit der unter Beispiel 3 beschriebenen Substanz sind.

ANWENDUNGSBEISPIEL:

Zu einer 10 Gew.%igen Lösung des Polymers gemäss Beispiel 4 in Cyclohexanon werden 10 Gew.% 4-Phenylthiophenyldiphenylsulfonium-Hexafluorarsenat [hergestellt gemäss J. Polymer Sci., Polymer Chem. Ed., 18, 2677-2695 (1980)], bezogen auf das Polymer, gegeben. Diese Lösung wird durch ein 0,5 Mikronfilter auf einen Silizium-Wafer getropft und mittels Schleuderbeschichtung (spin coating) wird ein homogener Film erzeugt. Der Polymerfilm wird bei 90° C während 20 Minuten getrocknet. Die Schichtdicke des amorphen, homogenen Films beträgt (0,5 µm). Durch eine Chrom-Quarzmaske wird der Film bei 254 nm mit einer Dosis von 1-2 $mJ/cm^2$ belichtet. Das belichtete Material wird anschliessend bei 90° C 10 Minuten lang entwickelt. Deutlich ist das hoch aufgelöste Maskenmuster zu erkennen. Die belichteten Zonen werden in einer RIE-Apparatur (Reactive Ion Etching) mit Sauerstoffplasma unter anisotropen Bedingungen ($O_2$-Fluss: 20 sccm/min, Druck: $4 \cdot 10^{-2}$ mbar, 35 Watt) freigeätzt, während die nicht belichteten Zonen nicht angegriffen werden. Messungen ergaben, dass belichtete Zonen etwa 30 mal schneller abgeätzt werden als nichtbelichtete Zonen. Mit dieser Technik gelingt es, selbst Submikronstrukturen im Resist trocken zu entwickeln.

## Patentansprüche

1. Organometallhaltige Styrolderivate der Formel I

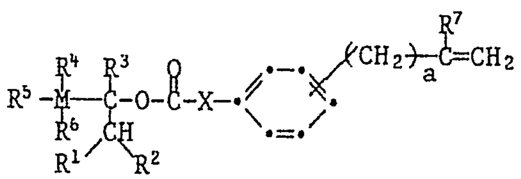 (I) ,

worin $R^1$ bis $R^6$ unabhängig voneinander $C_1$-$C_4$-Alkyl, $C_1$-$C_4$-Alkoxy, Phenyl, Benzyl, Phenoxy, eine Gruppe $-M(R^8)_3$ oder

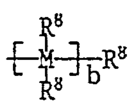 bedeuten

oder $R^3$ und $R^4$ zusammen für 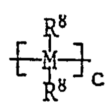

stehen und $R^1$ bis $R^3$ zusätzlich auch Wasserstoffatome sein können, $R^7$ Wasserstoff oder $C_1$-$C_4$-Alkyl und $R^8$ $C_1$-$C_4$-Alkyl, $C_1$-$C_4$-Alkoxy, Phenyl, Benzyl oder Phenoxy sind, M für Si, Ge, Sn, $CH_2Si$ oder OSi und X für O, S oder NH stehen und a Null oder 1, b eine ganze Zahl von 1 bis 6 und c eine ganze Zahl von 3 bis 6 bedeuten.

2. Styrolderivate nach Anspruch 1, worin M $CH_2Si$, OSi oder Si bedeutet.

3. Styrolderivate nach Anspruch 1, worin X S oder O bedeutet.

4. Styrolderivate nach Anspruch 1, worin $R^1$ und $R^2$ je Wasserstoff, $R^3$ Methyl oder $Si(CH_3)_3$ und $R^4$ bis $R^6$ je Methyl bedeuten oder worin $R^3$ und $R^4$ zusammen für

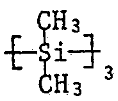 oder 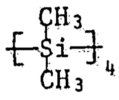

stehen.

5. Styrolderivate nach Anspruch 4, worin $R^1$ und $R^2$ je Wasserstoff, $R^3$ Methyl oder $Si(CH_3)_3$ und $R^4$ bis $R^6$ je Methyl bedeuten.

6. Styrolderivate nach Anspruch 1, worin a Null und $R^7$ Wasserstoff oder Methyl bedeuten.

7. 4-(2′-Trimethylsilyl-2′-propoxycarbonyloxy)styrol, 4-(2′-Trimethylsilyl-2′-propoxycarbonyloxy)-α-methylstyrol und 4-(1′,1′-Bistrimethylsilylethoxycarbonyloxy)-α-methylstyrol als Verbindungen der Formel I nach Anspruch 1.

8. Verfahren zur Herstellung von organometallhaltigen Styrolderivaten der Formel I nach Anspruch 1 entweder

a) direkt durch Umsetzung eines organometallhaltigen Alkohols der Formel II

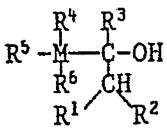 (II)

mit einem Chlorameisensäurederivat der Formel IIIa

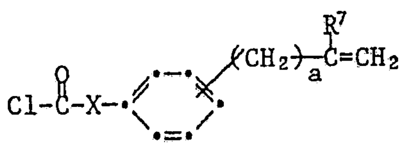 (IIIa)

oder durch Umsetzung eines organometallhaltigen Chlorformiats der Formel V

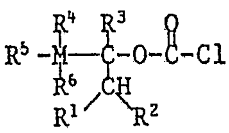 (V)

mit einer Verbindung der Formel VIa

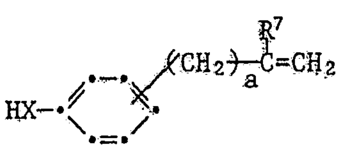 (VIa)

oder

b) über die entsprechenden Carbonylverbindungen durch Umsetzung des organometallhaltigen Alkohols der Formel II mit einem Chlorameisensäurederivat der Formel IIIb

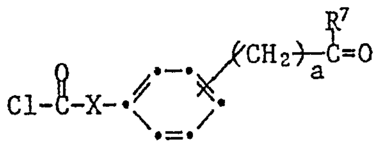

(IIIb)

zur Carbonylverbindung der Formel IV

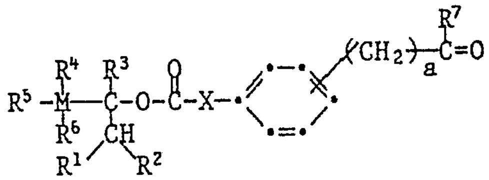

(IV) oder

durch Umsetzung des organometallhaltigen Chlorformiats der Formel V mit einer Verbindung der Formel VIb

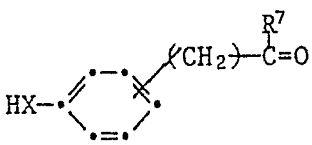

(VIb)

zur Verbindung der Formel IV und anschliessende Wittig-Reaktion der Carbonylverbindung der Formel IV mit einem Phosphorylid, wobei die Symbole $R^1$ bis $R^7$, M, X und a in den Formeln II bis VI die im Anspruch 1 angegebene Bedeutung haben.

9. Organometallhaltige Carbonylverbindungen der Formel IV

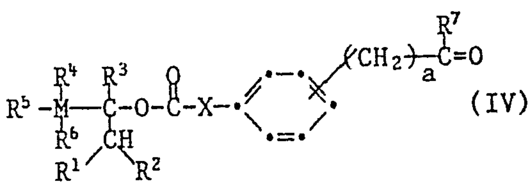

(IV),

worin $R^1$ bis $R^7$, M, X und a die im Anspruch 1 angegebene Bedeutung haben.

10. Organometallhaltige Verbindungen der Formel VII

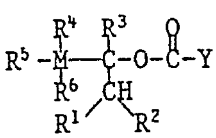

(VII) ,

worin $R^1$ bis $R^6$ und M die im Anspruch 1 angegebene Bedeutung haben und Y eine für eine nukleophile Substitution geeignete Abgangsgruppe ist.

11. Verbindungen nach Anspruch 10, worin Y für einen 1-Imidazolylrest oder für eine Gruppe der Formel VIII steht

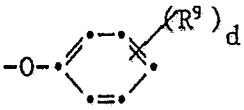 (VIII),

worin $R^9$ Halogen, $NO_2$, CN oder $CF_3$ und d eine ganze Zahl von 1 bis 5 bedeuten.

12. Verbindungen nach Anspruch 11, worin die Gruppe der Formel VIII 4-Nitrophenoxy ist.

13. Verfahren zur Herstellung von Verbindungen der Formel VII nach Anspruch 10 entweder durch Umsetzung eines organometallhaltigen Chlorformiats der Formel V nach Anspruch 8 mit einer Verbindung der Formel IX

YH (IX),

oder durch Umsetzung eines organometallhaltigen Alkohols der Formel II nach Anspruch 8 mit einem Chlorameisensäurederivat der Formel X

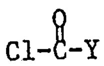 (X),

oder mit einer Carbonylverbindung der Formel XI

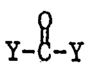 (XI),

wobei Y in den Formeln IX, X und XI die im Anspruch 9 angegebene Bedeutung hat.